# EUROPEAN PATENT APPLICATION

(11) **EP 4 112 928 A1**
(43) Date of publication of application: **04.01.2023**
(21) Application number: 21182159.0
(22) Date of filing: 28.06.2021
(51) Int. Cl.: F03D 17/00, H02G 13/00, G01R 27/16, G01R 27/20, G01R 31/28

(54) **LIGHTNING PROTECTION SYSTEM EVALUATION BASED ON IMPEDANCE ANALYSIS**

(71) Applicant: Siemens Gamesa Renewable Energy A/S, 7330 Brande (DK)
(72) Inventor: Nauheimer, Michael, 9000 Aalborg (DK)
(74) Representative: SGRE-Association

(57) **Abstract**

It is described a lightning protection system (100), in particular for a rotor blade (114), the system comprising:
i) a lightning conductor (110) for conducting electrical energy of a lightning; and
ii) a measurement device (150) electrically coupled to the lightning conductor (110) and configured to measure an impedance with respect to the lightning conductor (110).

Further, a rotor blade (114) and a wind turbine (101) are described.

## Description

### Field of invention

The present invention relates to a lightning protection system. In particular, the invention relates to a lightning protection system for a rotor blade. More in particular, the invention relates to a lightning protection system for a rotor blade of a wind turbine. The present invention relates further to a method of evaluating a lightning protection system. Furthermore, the invention relates to specific uses of an impedance measurement.

### Art Background

Lightning protection systems are applied to protect buildings and industrial constructions, such as wind turbines, from a lightning strike. In general, it may be said that a lighting protection system comprises a lightning conductor, e.g. implemented as a cable or rod, that guides the electric energy of the lighting towards ground, so that the construction to be protected is not harmed by the lighting strike.

In order to function properly in a dangerous situation, the lighting protection system has to be tested in advance, in particular on a regular basis. This may be done after production and/or after mounting the lighting protection system. In the following, the example of a lighting protection system established in a wind turbine blade will be discussed.

Prior to, during, and after the production and at operation of a wind turbine blade, the lightning protection system may be inspected. Conventionally, this is done by means such as visual inspection, electrical resistance measurement, ultrasound scanning, and infrared thermography testing. Thereby, the quality and functionality of the lightning protection system may be evaluated. Conventionally, the measurement of the electrical resistance of the lightning protection system may be considered a commonly used standard method for inspection of the lightning protection system of a wind turbine blade.

However, this approach has the drawback that it provides only a limited amount of information about the quality and functionality of the tested lightning protection system.

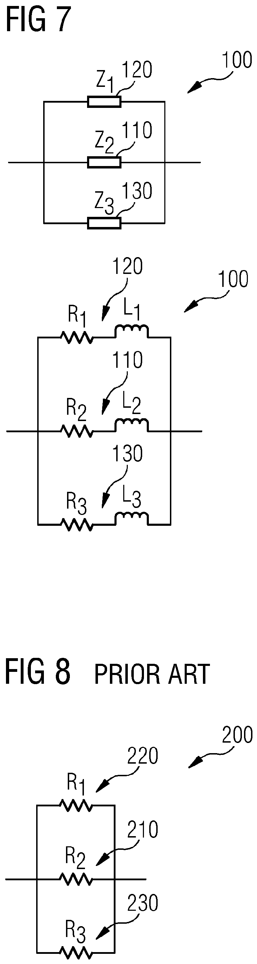

**Figure 8** shows a schematic conventional example 200, wherein, in a blade, there are utilized a blade (down) conductor 210 (comprises a resistance R2) and two electrically conductive spar caps (electrically conductive with respective resistances R1 and R3) 220, 230, all of which are electrically connected in parallel. The resistance measurement system can be simplified to describe the down conductor 210 and the two electrically conductive spar caps 220, 230 as three parallel resistances, as shown in the Figure 8. A measurement system would then apply a constant direct current (DC) voltage and measure the load (current) to determine the resistance of the system under test.

Usually, the electrical resistance of the blade down conductor is very low compared to the electrical resistance of the electrically conductive spar caps. Thus, when the electrically conductive spar caps are electrically connected in parallel with the blade down conductor, it may cause only a minor (and most likely insignificant) decrease in the resistance of the entire lightning protection system.

Since the electrical resistance is only slightly decreased, it may be hard to determine, if that difference is due to acceptable process and material variation or due to electrical connection/disconnection between the electrically conductive spar caps and the blade down conductor.

Furthermore, the existing methods also have limitations in detecting if there is a low-quality electric connection between the electrical conductors inside the blade.

An example could be a case where two electrically conducting elements (e.g. cable and cable, cable and carbon (electrically conductive), or carbon and carbon) are touching each other without being clamped, bolted, soldered, or welded together. In such a case, the evaluation of the resistance measurement would not indicate any issues within the lighting protection system. However, over time, the two electrically connected elements might lose the electrical connection due to blade structural effects such as blade movement or electrical affects due lightning strikes.

The conventional resistance measurement may be combined with further methods such as ultrasound and infrared thermography inspection, which can assist the resistance measurements by providing additional information. However, these combined processes may be especially time consuming.

There may be a need for providing a lighting protection system (in particular for a rotor blade) that can be evaluated in an efficient and reliable manner.

### Summary of the Invention

This need may be met by the subject matter according to the independent claims. Advantageous embodiments of the present invention are described by the dependent claims.

According to a first aspect of the invention, there is provided a lightning protection system, in particular for a rotor blade, more in particular for a wind turbine rotor blade, the system comprising:
i) a lightning conductor, e.g. a cable and/or a rod, for conducting electrical energy of a lightning (strike), and
ii) a measurement device electrically coupled (connected) to the lightning conductor and configured to measure an impedance with respect to the lightning conductor (the impedance of the lightning conductor).

According to a second aspect of the invention, there is described a rotor blade that comprises the lightning protection system described above.

According to a third aspect of the invention, there is described a wind turbine comprising: i) a tower, and ii) a wind rotor, which is arranged at a top portion of the tower, and which comprises at least one blade as described above.

According to a fourth aspect of the invention, there is described a method of evaluating a lightning protection system (in particular as described above) (in particular of a wind turbine rotor blade), the method comprising:
(providing an alternating current (AC) load to a lightning conductor of the lightning protection system, and sweeping the AC load over a plurality of frequencies, thereby)
i) measuring an impedance with respect to the lightning conductor, and
ii) evaluating the lightning protection system based on the impedance measurement (by an impedance analysis).

According to a fifth aspect of the invention, there is described a use (method of using) of an impedance analysis of a conductor (at least one of the group which consists of a lightning conductor, a conductor element, a further conductor element) in order to evaluate a lightning protection system of a rotor blade.

According to a sixth aspect of the invention, there is described a use (method of using) of an impedance analysis of a conductor of a lightning protection system in order to evaluate a rotor blade construction.

According to an exemplary embodiment, the invention may be based on the idea that a lighting protection system (in particular for a rotor blade), which can be evaluated in an efficient and reliable manner, can be provided when an impedance with respect to the lighting conductor is measured (and analyzed).

The impedance of a system may describe the ohmic resistance of an electrical system at different frequencies. Instead of applying a constant direct current as conventionally done (see Figure 8), an alternating current load (current /voltage) sweep over various frequencies may for example be performed and then the load (current/voltage) is measured to determine the impedance at different frequencies.

The described method may provide information that cannot be obtained by using conventional methods, e.g. resistance measurements. In other words, the described solution is supposed to work as a fast evaluation/test solution using only one method, whereas conventionally a combination of several time-consuming processes are used to obtain sufficient information.

For example, a frequency sweep could be done within a few minutes, whereas ultrasound inspection of the electrical connections could take several hours. Further, the latter is limited by accessibility to the components under test, which is not the case for the impedance measurement.

The described system may also be applied as a structural quality monitoring system, since changes in the blade structure could have an impact on the electrical connections of the lightning protection system, and thereby,
changes in the impedance measurements of the lightning protection system could indicate changes in the
structural quality of the blade construction.

The described measurement may not only be useful for estimation of resistive and inductive effects, but it may also be used to estimate capacitive effects of the electrical (lighting protection) system. Capacitive effects could e.g. be observed in cases where the elements have a connection, but for some reason the connection has degraded over time, e.g. structurally. Capacitive effects would have a reciprocal effect on the impedance compared to the inductive effects. The capacitive effects are expected to be an advantage, especially to observe if the impedance measurement
system is used for monitoring the quality of the lightning protection during the lifetime operation of the blade.

### Exemplary Embodiments

According to an embodiment, the lightning protection system further comprises an evaluation device configured to evaluate (by impedance analysis) the lightning protection system (in particular to determine a quality criterion) based on the impedance measurement.

Based on the measured impedance(s), an impedance analysis may be performed by a suitable evaluation device in a fast and efficient manner. The evaluation device may be implemented together with the measurement device or may be realized as a stand-alone unit. Further, the evaluation unit may also be established remote from the lighting protection system (and the rotor blade/wind turbine). In another example, the evaluation unit may be realized in a wind turbine control system.

According to a further embodiment, the measurement unit is configured (for measuring the corresponding impedance) to
i) provide an alternating current (AC) load (current or voltage) to the lightning conductor, and
ii) sweep the AC load over a plurality of frequencies.

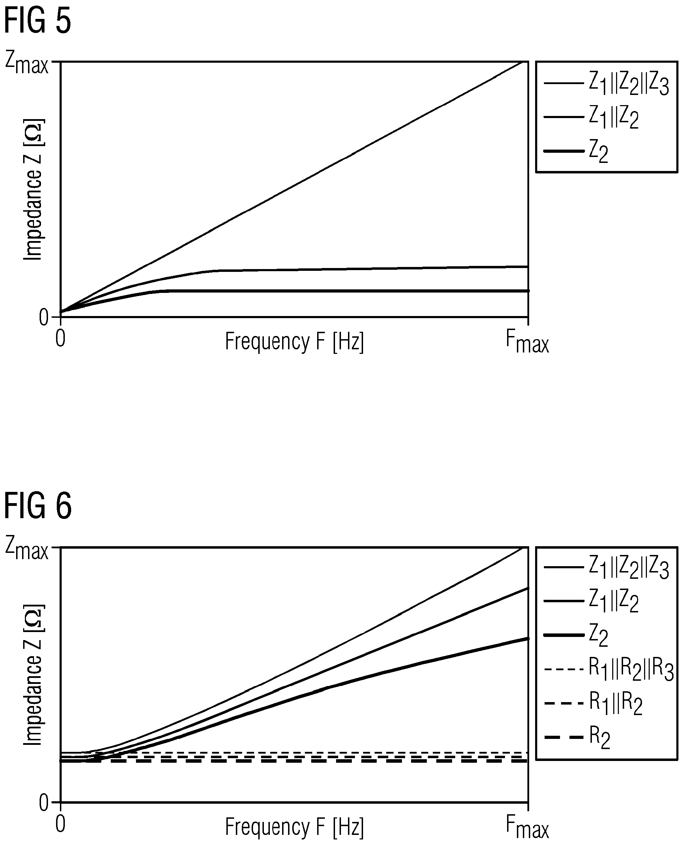

Using such a frequency sweep, the impedance (at different frequencies) may be measured in a fast and reliable manner (see e.g. Figures 5 and 6).

According to a further embodiment, the measurement unit is configured (for measuring the corresponding impedance) to apply a time domain based measurement.

In an example, time domain based methods, e.g. TDR (time domain reflectometry) is applied. Hereby, a number of electrical impulses may be used to determine the time domain characteristics of a transmission line. The time domain characteristics observed, when analyzing electrical systems using TDR, may be mainly dependent on variations in the electric field generated but also dependent on the impedance of the system under test.

Specifically, TDR may be able to measure reflections (same principle as a radar) along a conductor. The measurement system (e.g. time-domain reflectometer) emits a measurement signal onto the conductor and measures its reflections (reflected signal, in particular reflected waveform). Hereby, the magnitude of the reflected signal is, among other effects, dependent on the impedance of the transmission medium (i.e. the (different) conductor(s) in the blade electrical system).

According to a further embodiment, the lightning protection system further comprises at least one (preferably two or more, in particular three/four/five or more) conductor element(s) electrically coupled to the lightning conductor and/or the measurement device. In particular, the measurement device is then further configured to measure the impedance (and provide the AC load also to the conductor element) with respect to at least a part of the conductor element(s).

According to a further embodiment, the lightning conductor and the at least one conductor element, in particular two conductor elements, are electrically connected in parallel. In this manner, more (detailed) information with respect to the lighting protection system may be obtained. In particular, the impedance measurement result may be improved (see Figures 5 and 6 as an example).

According to a further embodiment, the measurement device comprises a first electrical connector and a second electrical connector, and both electrical connectors are connected to the lighting conductor or to the conductor element(s) (respectively) (see Figures 1 and 3 as examples). Alternatively, both electrical connectors may be connected to only one conductor element (see Figure 4 as an example)

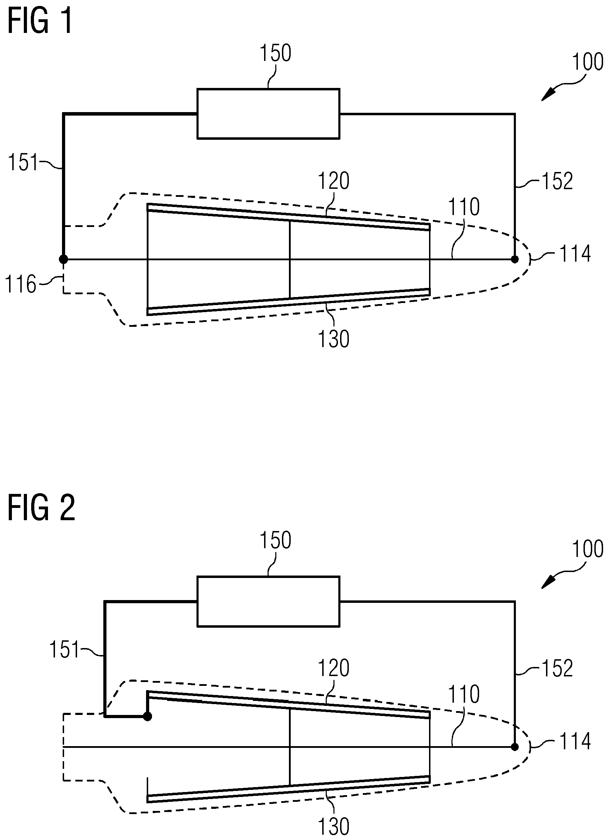

According to a further embodiment, the measurement device comprises a first electrical connector and a second electrical connector, the first electrical connector is connected to the conductor element, and the second electrical connector is connected to the lighting conductor (see Figure 2 as an example) .

The above described embodiments may be advantageously applied, when only certain parts of the lighting protection system/blade are tested, e.g. by being able to temporarily disconnect the conductive parts and test different configurations.

According to a further embodiment, wherein the lighting conductor is configured as one of a cable, a rod, a bar. The lighting conductor may comprise a standard design that is known to protect well against lighting strikes.

According to a further embodiment, the lightning protection system further comprises a spar cap which comprises or consists of the at least one conductor element.
In this manner, parts of a rotor blade may be directly applied within the lighting protection system without further effort/material.

According to a further embodiment, the method further comprises mounting the evaluated lightning protection system (in particular within a rotor blade), to a device to be protected, in particular a wind turbine.

In other words, the lighting protection system is (at least partially) evaluated/tested, before it is mounted to a rotor blade and/or wind turbine. For example, the lightning conductor (and/or the conductor elements) are evaluated before being mounted at a blade.

In an example, pre-cast/pre-fabricated electrical parts of the blade may be evaluated, before they are placed in a blade mold. In another example, pre-cast/pre-fabricated electrical parts of the blade and the (full) electrical system (comprising or consisting of the lighting protection system) of the blade may be evaluated before, during and/or after casting of the (full) blade. In a further example, the lighting protection system is evaluated on the (full) blade during operation of the blade and/or during blade testing.

This may provide the advantage that problems/failures of specific parts of the blade electrical system (comprising or consisting of the lighting protection system) may be identified based on impedance measurement (frequency response and/or TDR response), of the blade electrical system changes (compared to before testing/operation of the blade has been started).

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited.

### Brief Description of the Drawings

- Figures 1 to 4: show a lighting protection system for a rotor blade, respectively, in accordance with exemplary embodiments of the present invention.
- Figures 5 and 6: show a diagram to illustrate the impedance measurement, respectively, in accordance with exemplary embodiments of the present invention.
- Figure 7: illustrates an electric connection in a lighting protection system according to an exemplary embodiment of the present invention.
- Figure 8: shows a conventional example of a lighting protection system.

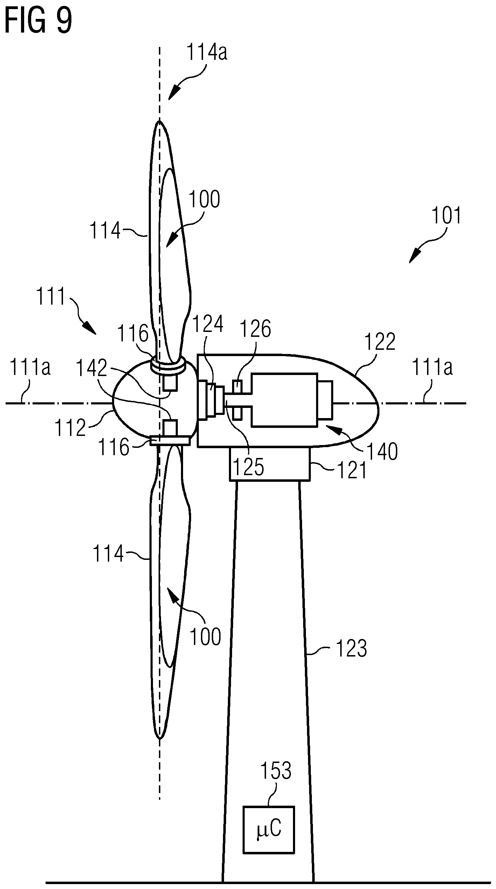

- Figure 9: shows a wind turbine in accordance with an exemplary embodiment of the present invention.

### Detailed Description of the Drawings

The illustration in the drawing is schematic. It is noted that in different figures, similar or identical elements or features are provided with the same reference signs or with reference signs, which are different from the corresponding reference signs only within the first digit. In order to avoid unnecessary repetitions elements or features which have already been elucidated with respect to a previously described embodiment are not elucidated again at a later position of the description.

Further, spatially relative terms, such as "front" and "back", "above" and "below", "left" and "right", et cetera are used to describe an element's relationship to another element(s) as illustrated in the figures. Thus, the spatially relative terms may apply to orientations in use which differ from the orientation depicted in the figures. Obviously all such spatially relative terms refer to the orientation shown in the figures only for ease of description and are not necessarily limiting as an apparatus according to an embodiment of the invention can assume orientations different than those illustrated in the figures when in use.

According to an exemplary embodiment, the described impedance measurement system provides an advantage in determining, if essential electrical components of the lightning protection system have been connected properly. With the results of resistance measurements, in contrast, it may not be conclusive if a satisfactory electrical connection exists between the electrically conductive elements (spar cap) and the blade lightning protection system. The same holds true for a monitoring using the present method, where impedances of the lightning protection system are measured during the lifetime of the blade, to determine if the quality changes over time. Here, the impedance measurements would also provide an improved method for determining the quality of the lightning protection system during the lifetime of the blade, e.g. during full-scale blade structural test or full-scale testing of the lightning protection system according to the standards given in IEC 61400-24.

According to a further exemplary embodiment, the impact of the described solution is a new and effective method for determining the quality of wind turbine blade lightning protection system before, during, and/or after production of the blade and turbine, together with a possibility to do repetitive testing of the lightning protection quality during the entire lifetime of the blade. This solution could be applied towards testing the lightning protection system of wind turbine blades before they leave the production facilities, to ensure quality and homogeneous performance across the different blades.

According to a further exemplary embodiment, the described method could in principle be used to measure the impedance between any (two) points in the electrical system of a blade. According to a further exemplary embodiment, the analysis of the conductor element(s) can be performed before connecting it with the rest of the lightning protection system. In that way the impedance analysis of the (separate) conductor elements can be done before connecting the elements, and when the result is compared to the analysis of the full system, additional knowledge of the impedance behavior can be obtained.

**Figure 1** shows a lighting protection system 100 for a rotor blade 114 according to an exemplary embodiment of the present invention. The rotor blade 114 is mounted via a blade adjustment device 116 to a rotor 111 of a wind turbine 101 (see Figure 9). The blade 114 comprises along its direction of main extension, essentially from tip to root, a lighting conductor 110, for conducting electrical energy of a lightning strike. The lighting conductor 110 is made of metal and is configured e.g. as a cable, a rod, or a bar. The blade 114 further comprises spar caps 120 and 130, respectively arranged above and below the lighting conductor 110 in the blade 114. These spar caps 120, 130 comprise an electrically conductive material (and are thus conductor elements) and are electrically connected to the lighting conductor 110. The spar caps 120, 130 can for example comprise carbon reinforced polymer composites.

The lighting protection system 100 further comprises a measurement device 150 that is electrically connected via a first electric connection 151 and a second electric connection 152 to the lightning conductor 110 (at the tip and at the root). The measurement device 150 is configured to provide, through the electric connections 151, 152, an alternating current (AC) load (e.g. a voltage or a current) to the lightning conductor 110. Hereby, the measurement device 150 sweeps the AC load over a plurality of frequencies, and measure the corresponding impedance with respect to the lightning conductor 110. The measurement device 150 is further configured to provide the AC load (and frequency sweep) also to the conductor elements 120, 130. The lightning conductor 110 and the conductor elements 120, 130 are electrically connected in parallel. In another example, the impedance is measured using a time domain reflectometry based method.

The lightning protection system 100 further comprises an evaluation device, that can be realized together with the measurement device 150, and that is configured to evaluate the lightning protection system 100 using an impedance analysis (of the impedance measurement). Such an evaluation may for example yield a quality criterion (e.g. functionality is fine, connection is fine, construction is fine) for the lightning protection system 100.

**Figure 2** shows a lighting protection system 100 for a rotor blade 114 according to another exemplary embodiment of the present invention. The design is very similar to Figure 1 with the difference that the first electric connection 151 of the measurement device 150 is not directly connected to the lightning conductor 110, but to the upper spar cap 120 (a conductor element).

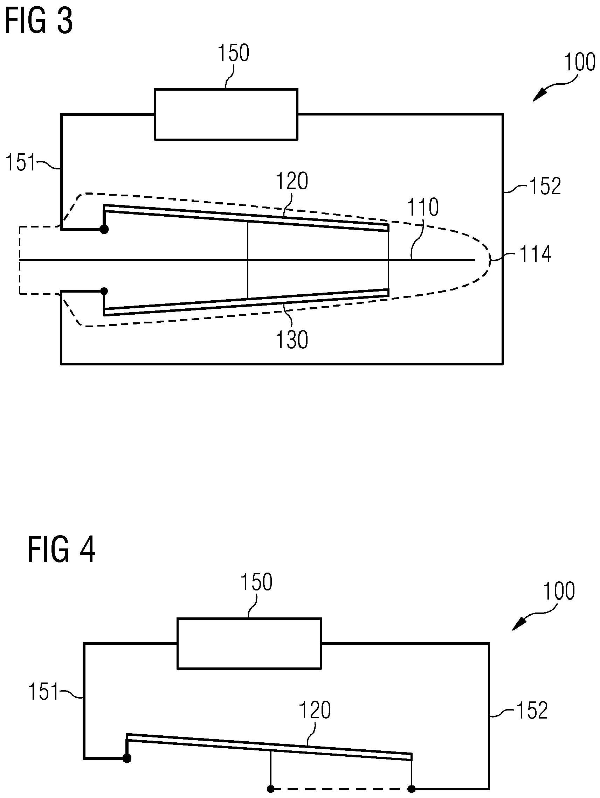

**Figure 3** shows a lighting protection system 100 for a rotor blade 114 according to another exemplary embodiment of the present invention. The design is very similar to Figure 1 with the difference that both electrical connectors 151, 152 of the measurement device 150 are connected to two conductor elements 120, 130, respectively.

**Figure 4** shows a lighting protection system 100 for a rotor blade 114 according to another exemplary embodiment of the present invention. The design is very similar to Figure 3 with the difference that both electrical connectors 151, 152 of the measurement device 150 are connected to only one conductor element 120. The conductor element 120 is further electrically coupled to the lighting conductor 110, so that the impedance of the latter can also be taken into account.

**Figure 5** shows a diagram to illustrate the impedance measurement/analysis according to an exemplary embodiment of the invention. The frequency F (see frequency sweep) is shown on the x-axis in Hertz (arbitrary values) and the corresponding impedance Z is shown in Ohm (arbitrary values) on the y-axis. Different results will be obtained, when measuring the impedance as follows (see Figure 7 for the definition of the impedances) :
i) only for the lighting conductor 110 (Z2, see also Figure 7),
ii) for the lighting conductor 110 and one conductor element 120 in parallel (Z1, Z2), or
iii) for the lighting conductor 110 and two conductor elements 120, 130 in parallel (Z1, Z2, Z3).

**Figure 6** shows a diagram to illustrate the impedance measurement/analysis according to another exemplary embodiment of the invention. The diagram is similar to Figure 5, but, for comparison, a conventional resistance measurement is shown (see Figure 8 for the definition of the resistors). Due to the applied direct current (constant frequency), there is no change in the frequency. Accordingly, the amount of information obtained by the conventional resistance measurement is much lower than the amount of information obtained by the described impedance measurement. In other words, Figure 6 shows the comparison between the resistance and impedance at different frequencies when the inductive effects of the conductors are either included or omitted.

In particular with increasing frequencies, the difference in impedance increases, making it possible to detect e.g. if an electrically conductive spar cap is not (properly) electrically connected with the rest of the lightning protection system.

**Figure 7** shows the electric connection in a lightning protection system 110 according to another exemplary embodiment of the invention. This simplification shows the lighting conductor 110 and the two (or more) electrically conductive spar caps 120, 130 as three series impedances (the coils L1-L3 are only shown to represent impedances in general). The resistances and inductances
follow the relations R1 ≈ R3, L1 ≈ L3, R1 > R2 and L1 < L2. Such a lightning protection system 110 has been applied, when measuring the results shown in Figures 5 and 6 above.

**Figure 9** shows a wind turbine 101 according to an exemplary embodiment of the invention. The wind turbine 101 comprises a tower 123 which is mounted on a ground (with a not depicted support structure). The wind turbine 101 can be located either onshore or offshore.

On top of the tower 123 there is arranged a nacelle 122. In between the tower 123 and the nacelle 122 there is provided a yaw angle adjustment portion 121 which is capable of rotating the nacelle 122 around a non-depicted vertical axis being aligned with the longitudinal extension of the tower 123. By controlling the yaw angle adjustment portion 121 in an appropriate manner it can be made sure that during a normal operation of the wind turbine 101 the nacelle 122 is always properly aligned with the current wind direction.

The wind turbine 101 further comprises a wind rotor 111 having three blades 114. In the perspective of Figure 9 only two blades 114 are visible. The rotor 111 is rotatable around a rotational axis 111a. The blades 114, which are mounted at a hub 112, extend radially with respect to the rotational axis 111a and rotate within the rotational plane 114a.

In between the hub 112 and a blade 114 there is respectively provided a blade pitch angle adjustment device 116 in order to adjust the blade pitch angle of each blade 114 by rotating the respective blade 114 around an axis being aligned substantially parallel with the longitudinal extension of the respective blade 114. By controlling the blade pitch angle adjustment device 116, the blade pitch angle of the respective blade 114 can be adjusted in such a manner that, at least when the wind is not too strong, a maximum wind power can be retrieved from the available mechanical power of the wind driving the wind rotor 111.

As can be seen from Figure 9, within the nacelle 122 there is provided a gear box 124. The gear box 124 is used to convert the number of revolutions of the rotor 110 into a higher number of revolutions of a shaft 125, which is coupled in a known manner to an electromechanical transducer 140. The electromechanical transducer is a generator 140. At this point it is pointed out that the gear box 124 is optional and that the generator 140 may also be directly coupled to the rotor 111 by the shaft 125 without changing the numbers of revolutions. In this case the wind turbine is a so called Direct Drive (DD) wind turbine.

Further, a brake 126 is provided in order to safely stop the operation of the wind turbine 101 or the rotor 111 for instance in case of emergency.

The wind turbine 101 further comprises a control system for operating the wind turbine 101 in a highly efficient manner. Apart from controlling for instance the yaw angle adjustment device 121, the depicted control system is also used for adjusting the blade pitch angle of the rotor blades 114 using actuators 116 in an optimized manner.

Each of the blades 114 comprises a lighting protection system 100 (see Figures 1 to 7). The control system 153 of the wind turbine 101 includes or is coupled to a lighting protection measurement device 150 that is configured to measure impedances within the lighting protection system 100. The control system 153 of the wind turbine 101 further includes or is coupled to an evaluation device 150 that is configured to evaluate the lighting protection system 100 based on the impedance measurement (by impedance analysis). Measurement device and evaluation device 150 can be implanted within one and the same device.

It should be noted that the term "comprising" does not exclude other elements or steps and the use of articles "a" or "an" does not exclude a plurality. Also elements described in association with different embodiments may be combined. It should also be noted that reference signs in the claims should not be construed as limiting the scope of the claims.

## Claims

1. A lightning protection system (100), in particular for a rotor blade (114), the system (100) comprising:
a lightning conductor (110) for conducting electrical energy of a lightning; and
a measurement device (150) electrically coupled to the lightning conductor (110) and configured to measure an impedance with respect to the lightning conductor (110) .

2. The lightning protection system (100) according to claim 1, further comprising:
an evaluation device (150) configured to evaluate the lightning protection system (100), in particular to determine a quality criterion, based on the impedance measurement.

3. The lightning protection system (100) according to claim 1 or 2, wherein the measurement device (150) is, for measuring the impedance, further configured to
provide an alternating current, AC, load to the lightning conductor (110), and
sweep the AC load over a plurality of frequencies.

4. The lightning protection system (100) according to any one of the preceding claims, wherein the measurement device (150) is, for measuring the impedance, further configured to perform a time domain based measurement, in particular time domain reflectometry, TDR.

5. The lightning protection system (100) according to any one of the preceding claims, further comprising:
at least one conductor element (120) electrically coupled to the lightning conductor (110) and/or the measurement device (150);
wherein the measurement device (150) is further configured to measure the impedance of at least a part of the conductor element (120).

6. The lightning protection system (100) according to claim 5, wherein the lightning conductor (110) and the at least one conductor element (120), in particular two conductor elements (120, 130), are electrically connected in parallel.

7. The lightning protection system (100) according to any one of the preceding claims,
wherein the measurement device (150) comprises a first electrical connector (151) and a second electrical connector (152), and
wherein both electrical connectors (151, 152) are connected to the lighting conductor (110) or to the conductor element (120) .

8. The lightning protection system (100) according to any one of the preceding claims,
wherein the measurement device (150) comprises a first electrical connector (151) and a second electrical connector (152),
wherein the first electrical connector (151) is connected to the conductor element (120), and
wherein the second electrical connector (152) is connected to the lighting conductor (110).

9. The lightning protection system (100) according to any one of the preceding claims,
wherein the lighting conductor (110) is configured as one of a cable, a rod, a bar; and/or
wherein the system (100) further comprises a spar cap which comprises or consists of the at least one conductor element (120, 130).

10. A rotor blade (114) that comprises the lightning protection system (110) according to any one of the preceding claims.

11. A wind turbine (101) comprising:
a tower (123); and
a wind rotor (111), which is arranged at a top portion of the tower (123), and which comprises at least one blade (114) according to claim 10.

12. A method of evaluating a lightning protection system (100), in particular according to any one of the claims 1 to 9, the method comprising:
measuring an impedance with respect to a lightning conductor (110) of the lighting protection system (100); and
evaluating the lightning protection system (100) based on the impedance measurement.

13. The method according to claim 12, further comprising:
mounting the evaluated lightning protection system (100), in particular within a rotor blade (114), to a device to be protected, in particular a wind turbine (101).

14. Using an impedance analysis of a conductor (110, 120, 130) in order to evaluate a lightning protection system (100) of a rotor blade (114).

15. Using an impedance analysis of a conductor (110, 120, 130) of a lightning protection system (100) in order to evaluate a rotor blade (114) construction.
